# EUROPÄISCHE PATENTANMELDUNG

(11) **EP 0 563 440 A1**
(43) Veröffentlichungstag der Anmeldung: **06.10.1993**
(21) Anmeldenummer: 92117683.0
(22) Anmeldetag: 16.10.1992
(51) Int. Cl.: H03C 3/22, H03C 3/02

(54) **Frequenzmodulierter VCO mit geringer Hubänderung**

(30) Priorität: 31.03.1992 DE 4210490
(71) Anmelder: ROBERT BOSCH GMBH, 70442 Stuttgart (DE)
(72) Erfinder: Festag, Winfried, Dipl.-Ing., W-1000 Berlin 41 (DE)

(57) **Zusammenfassung**

2.1. Der Erfindung liegt die Aufgabe zugrunde, einen frequenzmodulierten spannungsgesteuerten Oszillator (VCO) anzugeben, der eine geringe Hubänderung aufweist.

2.2. Die Aufgabe wird dadurch gelöst, daß ein aus einem einstellbaren Kondensator (C5) und einer Induktivität (L2) bestehender Schwingkreis des Oszillators über einen Kondensator (C6) und eine aus zwei Schottky-Dioden (V2, V3) sowie einem Widerstand (R4) bestehende Diodenklemmschaltung mit dem Eingang (Gate) eines in Drainschaltung arbeitenden Sperrschicht-Feldeffekttransistors (JFET) großer Steilheit verbunden ist, daß an der Drain-Elektrode des JFET eine positive Betriebsspannung parallel zu einer HF-Abblock-Kapazität (C2) liegt, daß der Ausgang des JFET über einen Widerstand (R5) mit einer Drossel (L3) sowie einem parallel dazu liegenden Kondensator (C7) verbunden ist, daß die Gate-Elektrode des JFET über einen Kondensator (C4) mit einem aus einer Kapazitätsdiode (V1), einer Induktivität (L1) und einem Kondensator (C3) bestehenden Abstimmkreis verbunden ist, daß die Diodenklemmschaltung des Oszillators mit einem aus drei Widerständen (R1, R2 und R3) bestehenden Spannungsteiler verbunden ist und daß über einen Kondensator (C1) und/oder eine Spannungsquelle an U+ der NF-mäßige Kurzschluß erfolgt.

2.3. Ein bevorzugtes Anwendungsgebiet ist der Einsatz in portablen Geräten der Kommunikationstechnik.

3. Die Zeichnung zeigt das Schaltbild des VCO.

## Beschreibung

Die Erfindung bezieht sich auf einen spannungsgesteuerten Oszillator (VCO) nach dem Oberbegriff des Anspruchs 1, der insbesondere für professionelle portable Geräte der Kommunikationstechnik geeignet ist und eine geringe Hubänderung aufweist. Sein Anwendungsbereich reicht von niedrigen Frequenzen bis in das UHF-Gebiet.

Es ist bekannt, die Frequenzmodulation des VCO mit einer zusätzlichen Kapazitätsdiode zu realisieren, indem den frequenzbestimmenden Elementen des Oszillators eine durch eine Modulationsspannung steuerbare Kapazitätsdiode zugeordnet ist. Weiterhin ist die zusätzliche Modulation der Abstimmungsspannung (Hubkompensation) bekannt, wobei die Modulationsempfindlichkeit der Abstimmdiode eine Funktion der Abstimmspannung ist.

Aufgabe der Erfindung ist die Angabe eines frequenzmodulierten VCO mit einer geringen Hubänderung.
Erfindungsgemäß wird diese Aufgabe durch die im Kennzeichen des Patentanspruchs aufgeführten Maßnahmen gelöst.

Der um den Abstimmkreis erweiterte Oszillator stellt einen spannungsgesteuerten Oszillator (VCO) dar, der außerdem niederfrequent frequenzmoduliert wird.

Die Frequenzmodulation erfolgt durch Variation des JFET-Arbeitspunktes, Da die Ausgangskennlinie bei dem verwendeten Hochstromfet bei dem hier vorliegenden sehr niedrigen Drainstrom von 1 bis 2 mA schon bei der ebenfalls verwendeten Drain-Source-Spannung von nur ca. 4,5 Volt sehr flach verläuft (großer differentieller Ausgangswiderstand), bleibt der Drainstrom und damit die Steilheit praktisch konstant, und es erfolgt im wesentlichen nur eine Veränderung der JFET-Kapazitäten. Diese bewirkt daher nur eine Frequenzmodulation mit extrem kleinem Klirrfaktor; die üblicherweise bei einer Arbeitspunktmodulation auch auftretende Amplitudenmodulation von bis zu 30 % bleibt hier weit unter 1 %.

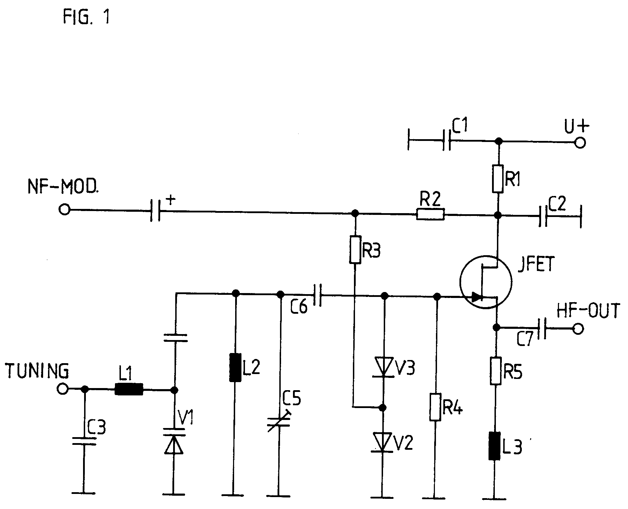

Die Hubeinstellung erfolgt über den Spannungsteiler mit den Widerständen R1, R2 und R3, der NF-mäßige Kurzschluß erfolgt über den Kondensator C1 und/oder die Spannungsquelle an U+; vgl. Fig. 1.

Des weiteren wird mit dem Widerstand R4 ein geringer Vorstrom im µA-Bereich durch die Diode V2 eingestellt, durch die NF-Modulation erfolgt eine Variation der Diodendurchlaßspannung und damit eine Veränderung der Richtspannung an der Diodenklemmschaltung, die den Hauptteil der negativen Gate-Vorspannung für den JFET erzeugt, und damit ebenfalls eine, allerdings sehr viel geringere, Arbeitspunktmodulation des JFET.

Bedingt durch die geringere Güte der Abstimmdiode V1 bei kleineren Abstimmspannungen, hier gleichbedeutend mit niedriger VCO-Schwingfrequenz, wird bei letzterer auch die Schwingkreisspannung und über die Diodenklemmschaltung auch die negative Gate-Vorspannung kleiner; aufgrund der nichtlinearen Steuerkennlinie des JFET wird damit die Steilheit größer, d.h. die Arbeitspunktmodulation wird größer mit abnehmender Frequenz.

Die Zuletzt genannte Modulation erzeugt somit einen mit abnehmender Schwingfrequenz steigenden Hub und kann daher die bei der zuerst genannten Modulation gegensinnige Tendenz, wie sie bei allen Frequenzmodulationsarten üblicherweise auftritt, die zur Modulation eine veränderliche Kapazität ausnutzen, kompensieren.

Die Art der Frequenzmodulation zeichnet sich nun dadurch aus, daß der Bauteileaufwand sehr gering ist und sich außerdem durch einen einzigen zusätzlichen Widerstand eine mehr oder weniger vollständige (je nach Schaltbandbreite und Parameterstreuungen der Bauelemente) Kompensation der Hubänderung über die Schaltbandbreite des VCO erreichen läßt. Außerdem läßt sich mit dieser Methode sowohl der Modulationsklirrfaktor als auch der Anteil der Amplitudenmodulation deutlich unter 1% halten.

Ein vorteilhaftes Ausführungsbeispiel der Erfindung ist in der Zeichnung dargestellt und wird im folgenden näher erläutert.

Es zeigt:
- Fig. 1: das Schaltbild des erfindungsgemäßen VCO mit geringer Hubänderung

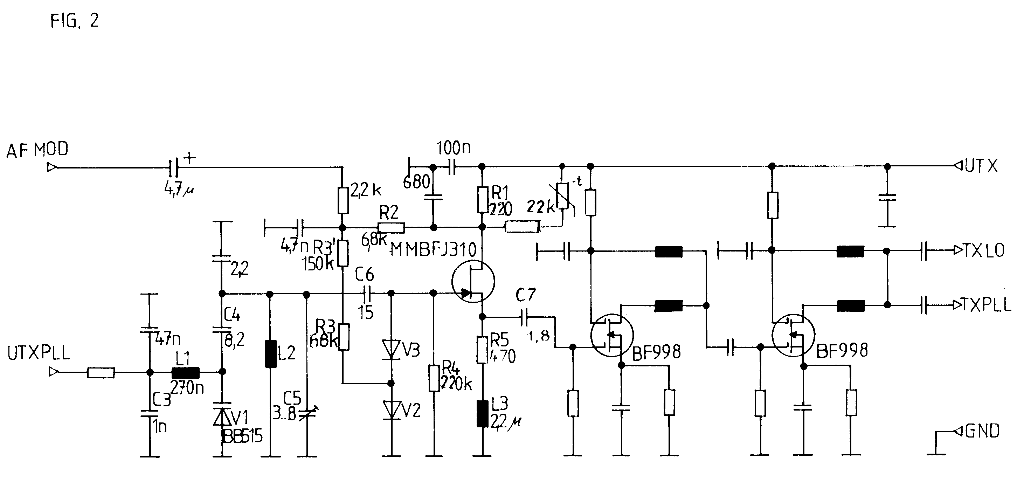

- Fig. 2: den erfindungsgemäßen VCO als Kernstück einer Senderfrequenzaufbereitung für Handfunksprechgeräte
Der für den VCO verwendete Hochstrom-JFET Typ 310 gestattet die Realisierung eines einfachen und universellen Oszillators, der von niedrigen Frequenzen bis in das UHF-Gebiet arbeitet. Durch die erfindungsgemäße Schaltung erfolgt eine zweifache Arbeitspunktmodulation des in Drainschaltung arbeitenden JFET. Die Hubeinstellung erfolgt über den Spannungsteiler aus den Widerständen R1, R2 und R3, wobei hier R3 eine Reihenschaltung der Widerstände R3 und R3' darstellt.
Eine zweite, sehr viel geringere Arbeitspunktmodulation erfolgt durch die Variation der Diodendurchlaßspannung durch V2 infolge der NF-Modulation. Der zwischen beiden Modulationsarten bestehende umgekehrte Zusammenhang zwischen Frequenzhub- und VCO-Schwingfrequenz bewirkt die erfindungsgemäße Kompensation der Hubänderung. Diese ist kleiner oder gleich 5% über die Schaltbandbreite.

Durch die Verwendung relativ weniger Bauteile und die geringe Stromaufnahme des Oszillators eignet sich der vorgeschlagene VCO besonders als Kernstück einer Senderfrequenzaufbereitung für Handfunksprechgeräte.

## Patentansprüche

1. Frequenzmodulierter spannungsgesteuerter Oszillator (VCO) mit geringer Hubänderung, **dadurch gekennzeichnet,** daß ein aus einem einstellbaren Kondensator (C5) und einer Induktivität (L2) bestehender Schwingkreis des Oszillators über einen Kondensator (C6) und eine aus Zwei Schottky-Dioden (V2, V3) sowie einem Widerstand (R4) bestehende Diodenklemmschaltung mit dem Eingang (Gate) eines in Drainschaltung arbeitenden Sperrschicht-Feldeffekttransistors (JFET) großer Steilheit verbunden ist, daß an der Drain-Elektrode des JFET eine positive Betriebsspannung parallel zu einer HF-Abblock-Kapazität (C2) liegt, daß der Ausgang des JFET über einen Widerstand (R5) mit einer Drossel (L3) sowie einem parallel dazu liegenden Kondensator (C7) verbunden ist, daß die Gate-Elektrode des JFET über einen Kondensator (C4) mit einem aus einer Kapazitätsdiode (V1), einer Induktivität (L1) und einem Kondensator (C3) bestehenden Abstimmkreis verbunden ist, daß die Diodenklemmschaltung des Oszillators mit einem aus drei Widerständen (R1, R2 und R3) bestehenden Spannungsteiler verbunden ist und daß über einen Kondensator (C1) und/oder eine Spannungsquelle an U+ der NF-mäßige Kurzschluß erfolgt.
